# EUROPEAN PATENT APPLICATION

(11) **EP 1 790 411 A1**
(43) Date of publication of application: **30.05.2007**
(21) Application number: 06256020.6
(22) Date of filing: 24.11.2006
(51) Int. Cl.: B01J 19/00, B01L 3/00

(54) **Apparatus for organic synthesis and reactions**

(30) Priority: 25.11.2005 JP 2005339570; 13.04.2006 JP 2006110573
(71) Applicant: JEOL Ltd., Akishima, Tokyo 196 (JP); KANAGAWA ACADEMY OF SCIENCE AND TECHNOLOGY, Kawasaki-shi, Kanagawa-ken 213-0012 (JP)
(72) Inventor: Takahashi, Yutaka, Tokyo 189-0024 (JP); Kitamori, Takehiko, Tokyo 113-0033 (JP)
(74) Representative: Cross, Rupert Edward Blount

(57) **Abstract**

An organic synthesis microreactor is offered which can be used in combination with many analytical instruments. The reactor mixes fluids in a very narrow space and causes the fluids to react in multiple stages. The reactor consists of an introduction portion (2,22,52) and a reaction portion (1,21,51) disconnectably connected with the introduction portion. The introduction portion introduces reagents from channels and, if necessary, mixes and reacts the reagents. The reaction portion accepts a reagent or reaction liquid from the introduction portion and mixes and reacts the reagent or reaction liquid with other reagent. The introduction portion has an inlet channel (6,26,57) and a first discharge channel. The inlet channel accepts a reagent from the outside and introduces the reagent into the reaction portion. The first discharge channel discharges the reaction liquid, which is discharged from the reaction portion, to the outside. The reaction portion has a reaction channel (10,31,62) in communication with the inlet channel to mix and react reagents sent in from the inlet channel. The reaction portion further includes a second discharge channel for connecting the reaction channel (13,34,65) and the first discharge channel to return the reaction liquid produced in the reaction channel to the introduction portion.

## Description

### BACKGROUND OF THE INVENTION

### 1. Field of the Invention

The present invention relates to an apparatus for organic synthesis and reactions and, more particularly, to an apparatus which is used for organic synthesis and reactions and permits analysis of reaction mechanisms and reaction intermediate structures.

### 2. Description of the Related Art

A technique for causing plural substances to mix and react with each other in a quite small space is known as microchip technology or microreactor technology and expected to be put into practical use to provide increased chemical reaction rates and improved efficiencies.

Microchip reactors for chemical synthesis are often made of glass because of its excellent chemical resistance. Since it is difficult to directly connect a tube, which is used to introduce a synthesis reagent, with a microchannel in a microchip made of glass, it is customary to connect the tube with a holder via a connector after the microchip reactor is held with the holder.

At tube joints, O-rings are of ten used to prevent liquid leakage. Therefore, eluates from rubber members and dead volume often present problems. In one available method, a tube is adhesively fixed to the surface of a glass reactor. However, depending on the solvent used, there is the possibility that the adhesive dissolves out. Furthermore, it is possible to machine a threaded structure into a glass material, the structure being used for connection of tubes of liquid chromatographs. Nonetheless, high level of technique is required to machine the structure, and high cost is necessary.

Furthermore, a reagent solution having high viscosity may be used depending on the kind of synthesis reaction. The reagent may clog up the channel after introduction of the reagent. Especially, the channel tends to be clogged up near tube joints.

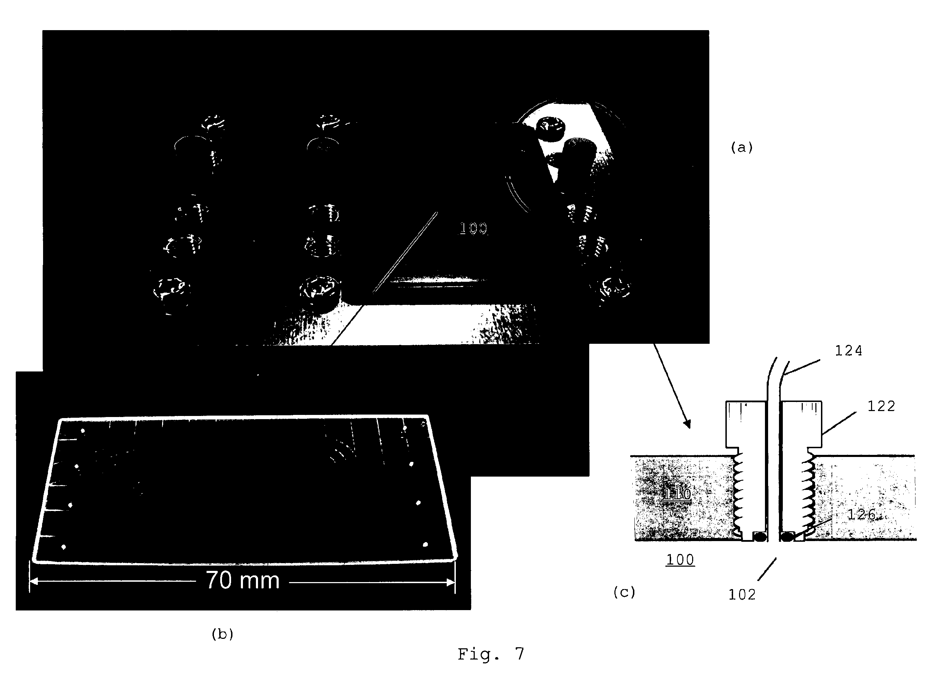

Microreactor products used for chemical synthesis have already been sold from some manufacturers. The microreactors are chiefly made of glass. A commercially available microreactor 100 for mixing of two reagents is shown in Fig. 7a-c. The glass microreactor 100 is composed of two plates. A microchannel is formed in one of the plates. A fluid inlet hole 102 and a fluid exit hole are formed in the other. The two plates are bonded together by thermocompression.

This microreactor is held to a holder 110. Tubes 124 for introduction of reagents are connected with the microreactor using connectors 120. Fig. 7c shows the structure of a connector 120. A Teflon^{™} screw 122 is screwed into the chip holder 110 and into contact with the glass chip 100. A Teflon^{™} tube 124 passes through the screw 122 to the fluid inlet hole 102. An O-ring seal 126 is provided between the screw 122 and the glass microreactor 100. The tubes 124 are connected with syringe pumps. Reagent solutions are introduced into the microreactor by the syringe pumps. The introduced reagents are made to meet at the Y-shaped portion of the channel and mixed. The reagents are made to react with each other in the downstream channel, thus producing reaction products.

A well-known on-line method of detecting reaction products is a thermal lens microscope technique. Where a measurement is performed using a mass spectrometer (MS) or nuclear magnetic resonance spectrometer (NMR) to make structural analysis of reaction products, it is required that the reaction products be collected at the exit of the microreactor and that the sample be introduced into the MS or NMR off-line.

Vigorous research is now underway to connect a microchip reactor or microreactor having various functions with an MS or NMR having high qualitative analysis capabilities in an on-line manner to perform analyses. There are the following research reports:

### (1) Microchip-NMR

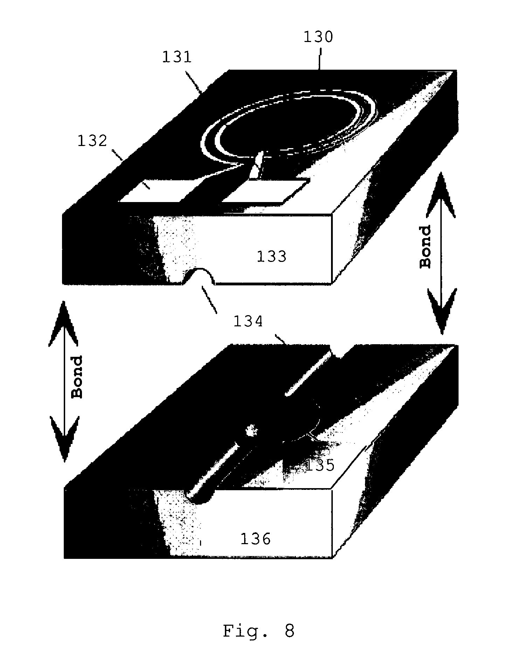

A monograph has been published describing a research in which a circular liquid reservoir is formed in a channel within a microchip reactor as shown in Fig. 8, a microcoil is brought close to the reservoir, and a trace amount of sample is investigated. Microcoils or probes dedicated for microchip reactors are at a research stage. There are almost no applications to chemical synthesis.

Itemreferences for figure 8 are as follows: Helmholtz MicroCoil 130; electrical bridge 131; bonding pads 132; glass substrate 133; fill channels 134; sample chamber 135; and glass substrate 136.

### (2) Flow NMR

Reaction reagents are mixed and reacted with each other using a static mixer. The reaction liquid is guided into a probe for flow NMR via a line, and an NMR measurement is performed. This research is at a practical level. The experiment needs a flow NMR probe. Furthermore, there is a drawback that the distance from the reaction portion to the position in the NMR magnet irradiated with an RF magnetic field is long.

### (3) Microchip-MS

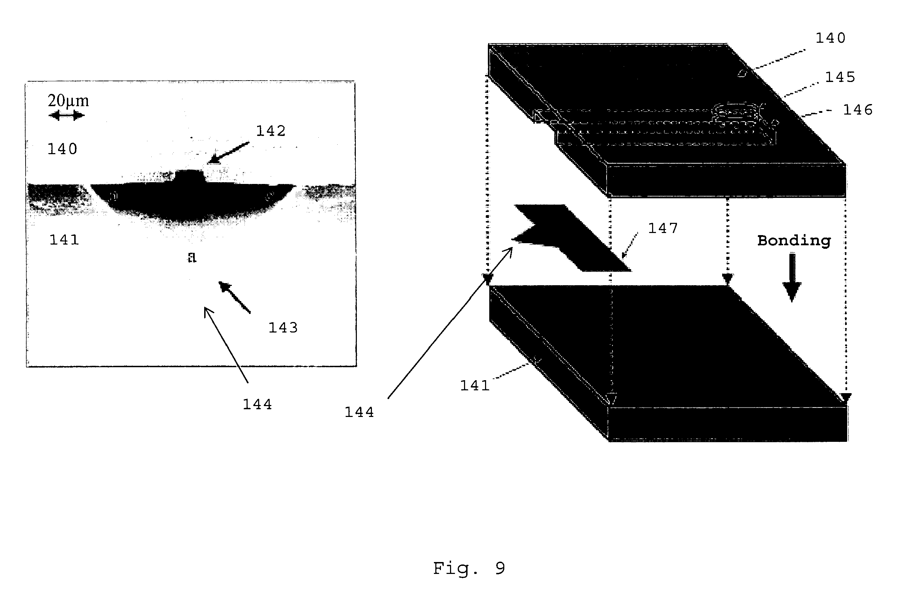

As shown in Fig. 9, when a microchip reactor is fabricated, a nanoelectrospray (ESI) nozzle is integrated with the microchip reactor. Mass analysis is enabled by applying a high voltage to the nozzle. There are more applications in the biological field than in synthetic chemistry.

The item references for figure 9 are as follows: top plastic chip 140; bottom plastic chip 141; channel exit 142; triangle tip 143; nano ESI spray nozzle 144; reservoir hole 145; embossed fluidic channel; and emitter film 147.
[Non-patent reference 1] Japanese Utility Model No. S57-75558
[Non-patent reference 2] Published Technical Report No. 2004-502547 of the Japan Institute of Invention and Innovation
[Non-patent reference 3] J.H. Walton et al., Analytical Chemistry, Vol. 75, pp. 5030-5036 (2003)
[Non-patent reference 4] J. Kameoka et al., Analytical Chemistry, Vol. 74, pp. 5897-5901 (2002)

Microchip reactors and microreactors for chemical analysis have the following problems:
(1) Since the microreactor is of the integrated construction, parts cannot be replaced. Therefore, if the channel or a tube joint is clogged up, the whole microreactor must be replaced. If the microreactor is made of glass, the running cost is high.
(2) Eluates from the material of the connector and dead volume present problems.
(3) When reaction products are detected on-line, usable detectors are limited to those using absorption of light.
(4) When structural analysis of reaction products is performed using an analytical instrument, it is normally necessary to introduce a sample in an off-line manner.

Where on-line detection using a combination of a microchip reactor and an analytical instrument consistingof anNMR is performed, there are the following problems.
(1) It is necessary to design and develop a dedicated NMR probe. This needs an exorbitant amount of initial investment.
(2) Since the design of the microchip reactor is dedicated for NMR, it is difficult to connect the reactor directly with other detectors.

Where on-line detection using a combination of a microchip reactor and an analytical instrument consisting of a flow NMR spectrometer is performed, there are the following problems.
(1) It is necessary to design and develop a dedicated flow probe. This necessitates a huge amount of initial investment.
(2) It is difficult to place the reaction portion into the probe. Normally, the reaction portion is placed outside the magnet. Consequently, there is a time lag from reaction to detection.

Where on-line detection using a combination of a microchip reactor and an analytical instrument consisting of an MS is performed, there are the following problems.
(1) There are only few examples of application to chemical synthesis.
(2) The design of the microchip reactor is dedicated for MS. It is difficult to connect the microchip reactor directly with other detectors.

### SUMMARY OF THE INVENTION

The present invention has been made in view of the foregoing problems. It would be desirable to provide a microchip reactor which is for use in organic synthesis and which can be used in combination with many analytical instruments.

In accordance with the invention, there is provided an organic synthesis reactor in which fluids are mixed in a very narrow space and reacted in multiple stages. The reactor has an introduction portion for introducing plural reagents from plural channels and a reaction portion disconnectably connected with the introduction portion. Where needed, the introduction portion mixes the introduced reagents and causes them to react with each other. In the reaction portion, a reagent or reaction liquid introduced from the introduction portion is mixed and reacted with other reagent. The introduction portion has an inlet channel for introducing a reagent, introduced from the outside, into the reaction portion and a first discharge channel for discharging the reaction liquid, discharged from the reaction portion, to the outside. The reaction portion has a reaction channel in communication with the inlet channel and a second discharge channel. The reaction channel causes plural reagents sent in from the inlet channel to mix and react. The second discharge channel places the reaction channel into communication with the first discharge channel to return the reaction liquid produced in the reaction channel to the introduction portion.

In one embodiment of the invention, the introduction portion is a microchip having a substrate made of a resin having chemical resistance. The substrate is provided with a microchannel. The reaction portion is a microchip having a substrate made of glass or quartz, the substrate being provided with a microchannel.

In another embodiment of the invention, the introduction portion has an inlet hole for introducing a reagent and a discharge hole for discharging the reaction liquid. The inlet hole and the discharge hole are flush with each other.

In a further embodiment of the invention, the microchannels are formed on both surfaces of the substrate made of glass or quartz by wet etching or drilling. Then, the substrate having the microchannels is sandwiched between two plates of glass or quartz. The substrate and the plates are bonded together by thermocompression, thus completing the reactor.

In a yet other embodiment of the invention, the substrate has a thickness of 1 to 5 mm.

In an additional embodiment of the invention, the reaction portion has been finished in a cylindrical or prismatic form having a length of 50 to 300 mm and a maximum width of 2 to 10 mm.

In a still other embodiment of the invention, the microchannels have a width and a depth of 50 to 500 µm.

In a yet additional embodiment of the invention, the reaction portion has a detection portion used in combination with an analytical instrument for analyzing the reaction liquid.

In a still further embodiment of the invention, the analytical instrument is at least one of NMR, ESR, and thermal lens microscope.

In an additional embodiment of the invention, an electrospray nozzle for use in combination with a mass spectrometer (MS) for analyzing the reaction liquid is mounted in the discharge hole in the introduction portion for discharging the reaction liquid.

Because the organic synthesis reactor according to an embodiment of the present invention is designed as described above, the reactor can be fabricated in a microchip form capable of being used in combination with many analytical instruments.

Other preferred embodiments of the invention will appear in the course of the description thereof, which follows.

### BRIEF DESCRIPTION OF THE DRAWINGS

Fig. 1 shows an organic synthesis reactor according to one embodiment of the present invention.
Fig. 2 shows an organic synthesis reactor according to another embodiment of the invention.
Fig. 3 shows an organic synthesis reactor according to a further embodiment of the invention.
Fig. 4 is a cross-sectional view of a thermal lens microscope that embodies an organic synthesis reactor according to an embodiment of the invention.
Fig. 5 is a cross-sectional view of an NMR spectrometer that embodies an organic synthesis reactor according to an embodiment of the invention.
Fig. 6 is a cross-sectional view of a mass spectrometer that embodies an organic synthesis reactor according to an embodiment of the invention.
Fig. 7 shows a commercially available microchip.
Fig. 8 shows a related-art technique in which a microchip is applied to an NMR spectrometer. The figure shows a perspective break away of Helmholtz fabrication, from non-patent reference 3.
Fig. 9 shows another related-art technique in which a microchip is applied to a mass spectrometer, from non-patent reference 4.

### DESCRIPTION OF THE PREFERRED EMBODIMENTS

Embodiments of the present invention are hereinafter described with reference to the accompanying drawings.

### First Embodiment

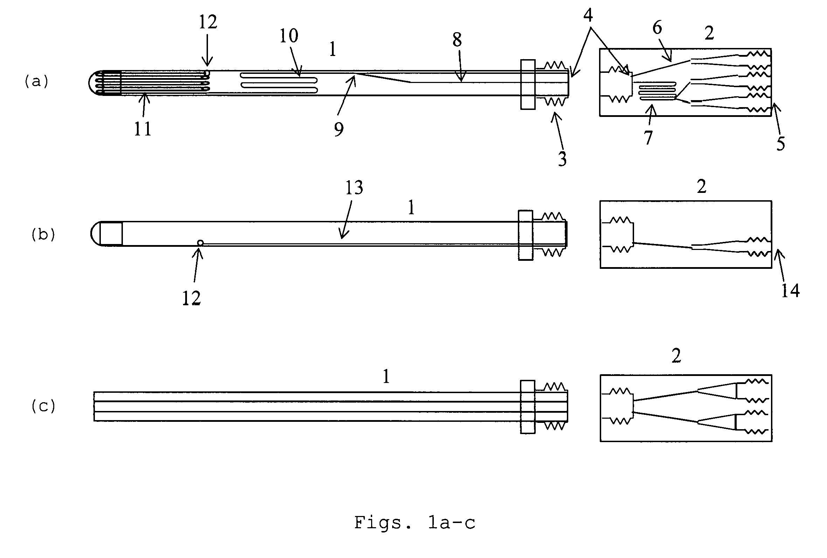

Referring to Fig. 1, there is shown an organic synthesis reactor according to one embodiment of the present invention. Figs. 1a-c show top, bottom and side views, respectively. The reactor has a reagent introduction-and-reaction portion 2 that is connected at a contact portion 4 with an extensional reaction portion 1 via a connector jig 3.

The extensional reaction portion 1 is made of a glass substrate having a thickness of 1 to 5 mm. Microchannels are formed on both surfaces of the glass substrate by wet etching or drilling. The glass substrate is provided with a through-hole 12 to permit a reagent solution to flow from the channel in the front surface to the channel in the rear surface.

The width and depth of the channels are 50 to 500 µm. The design of the channels and machining method can be modified according to the purpose of use.

The glass substrate having the microchannels are then held between two glass plates. These glass substrate and glass plates are bonded together by thermocompression. The whole assembly is finished in a cylindrical or prismatic form by a cutting technique. Alternatively, a glass stock may be machined into a semicylindrical form, and microchannels may be formed in this semicylindrical form. Preferably, the length of the extensional reaction portion 1 is 50 to 300 mm. The diameter of the cylindrical form or the maximum width of the prismatic form is 2 to 10 mm.

Screw holes are formed in the reagent introduction-and-reaction portion 2 to permit connection of tubes. Also, channels are formed in this portion 2. When the extensional reaction portion 1 and the reagent introduction-and-reaction portion 2 have been connected, their channels are aligned. Consequently, a reagent solution can be passed through the channels.

The connector jig 3 has guide portions to facilitate aligning the extensional reaction portion 1 and reagent introduction-and-reaction portion 2. The contact portion 4 is surface-treated or used in combination with a sealant to prevent liquid leakage.

Three reagent inlet holes 5 are formed in the reagent introduction-and-reaction portion 2. Two of the 3 inlet holes 5 meet each other and are combined into one conduit immediately ahead of a first reaction portion 7 formed within the reagent introduction-and-reaction portion 2. The conduit passes through the first reaction portion 7 of the bent channel, where a first reaction between reagents is produced. The conduit is in communication with a first reaction liquid channel 8 formed in the extensional reaction portion 1.

A reagent inlet channel 6 extends from the remaining one of the reagent inlet holes 5 and meets the first reaction liquid channel 8 in a second reaction-and-mixture portion 9 formed in the extensional reaction portion 1, thus forming one conduit. This conduit is in communication with a second reaction portion 10 of the bent channel, where a second reaction between the reagents is induced.

The second reaction portion 10 is in communication with a detection channel 11 of the bent channel. The second reaction portion 10 passes through a through-hole 12 and reaches the rear side of the extensional reaction portion 1, the through-hole 12 being formed in the vertical direction. The second reaction portion 10 then passes into the reaction liquid discharge hole 14 through a reaction liquid discharge channel 13. The 3 reagent inlet holes 5 and reaction liquid discharge hole 14 are formed in the same side surface of the reagent introduction-and-reaction portion 2.

In this way, in the present embodiment, the microchannels in the microchip are formed in both top surface side and bottom surface side of the reagent introduction-and-reaction portion 2 and extensional reaction portion 1. That is, the present embodiment is characterized in that there are two layers of channels.

Preferably, the material of the organic synthesis reactor is so selected that the reactor can be used in a temperature range from -70°C to +200°C. To permit mass production using a molding technique, the reagent introduction-and-reaction portion 2 is preferably made of a chemical resistant resin such as PEEK (polyetheretherketone), Teflon^{™}, or Diflon. Preferably, the extensional reaction portion 1 is made of glass or quartz.

Where viscous reagents are used, the channels inside the reagent introduction-and-reaction portion 2 tend to be clogged up especially easily. Consequently, it can be anticipated that the running cost of the reactor in operation will be reduced by designing this portion tending to be clogged up as a replaceable external part attached to the extensional reaction portion 1.

### Second Embodiment

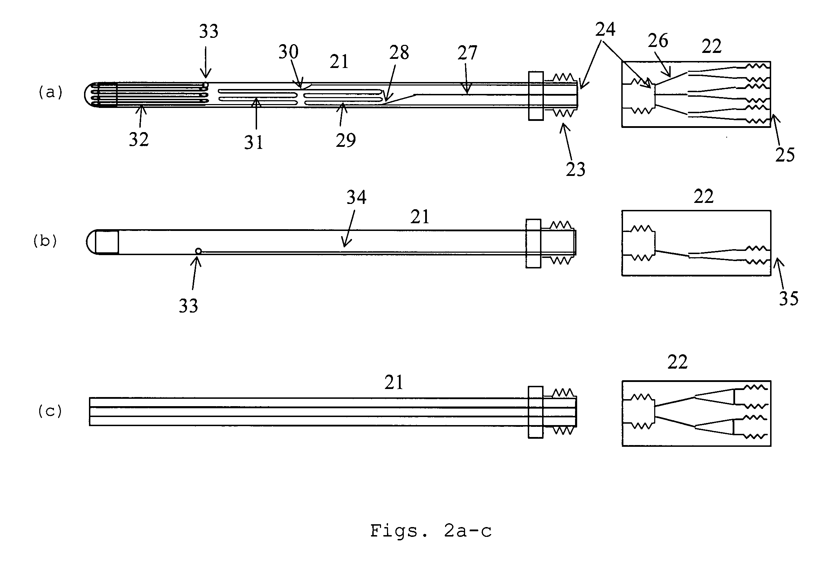

Fig. 2 shows an organic synthesis reactor according to another embodiment of the present invention. Figs. 2a-c show top, bottom and side views, respectively. The reactor has a reagent inlet portion 22 that is connected at a contact portion 24 with a reagent reaction portion 21 via a connector jig 23.

The reagent reaction portion 21 is made of a glass substrate having a thickness of 1 to 5 mm. Microchannels are formed on both surfaces of the glass substrate by wet etching or drilling. The glass substrate is provided with a through-hole 33 to permit a reagent solution to flow from the channel in the front surface to the channel in the rear surface.

The width and depth of the channels are 50 to 500 µm. The design of the channels and machining method can be modified according to the purpose of use.

The glass substrate having the microchannels are then held between two glass plates. These glass substrate and glass plates are bonded together by thermocompression. The whole assembly is finished in a cylindrical or prismatic form by a cutting technique. Alternatively, a glass stock may be machined into a semicylindrical form, and microchannels may be formed in this semicylindrical form. Preferably, the length of the reagent reaction portion 21 is 50 to 300 mm. The diameter of the cylindrical form or the maximum width of the prismatic form is 2 to 10 mm.

Screw holes are formed in the reagent inlet portion 22 to permit connection of tubes. Also, channels are formed in the inlet portion 22. When the reagent reaction portion 21 and the reagent inlet portion 22 have been connected, their channels are aligned. Consequently, a reagent solution can be passed through the channels.

The connector jig 23 has guide portions to facilitate aligning the reagent reaction portion 21 and reagent inlet portion 22. The contact portion 24 is surface-treated or used in combination with a sealant to prevent liquid leakage.

Three reagent inlet holes 25 are formed in the reagent inlet portion 22 and are in communication with three reaction liquid channels 27, respectively, formed in the reagent reaction portion 21.

Two of the 3 inlet holes 25 meet each other and are combined into one conduit in the first reaction-and-mixture portion 28. The conduit is in communication with the first reaction portion 29 of the bent channel, where a first reaction between reagents is produced. The conduit then meets another reaction liquid channel 27 in the second reaction-and-mixture portion 30 to form one conduit which is in communication with the second reaction portion 31 of the bent channel, where a second reaction between the reagents is induced.

The second reaction portion 31 is in communication with a detection channel 32 of the bent channel. The detection channel 32 passes through a through-hole 33 and reaches the rear side of the reagent reaction portion 21, the through-hole 33 being formed in the vertical direction. The second reaction liquid then passes into the reaction liquid discharge hole 35 through a reaction liquid discharge channel 34. The 3 reagent inlet holes 25 and reaction liquid discharge hole 35 are formed in the same side surface of the reagent inlet portion 22.

In this way, in the present embodiment, the microchannels in the microchip are formed in both top surface side and bottom surface side of the reagent inlet portion 22 and reagent reaction portion 21. That is, the present embodiment is characterized in that there are two layers of channels.

Preferably, the material of the organic synthesis reactor is so selected that the reactor can be used in a temperature range from -70°C to +200°C. To permit mass production using a molding technique, the reagent inlet portion 22 is preferably made of a chemical resistant resin such as PEEK (polyetheretherketone), Teflon^{™}, or Diflon. Preferably, the reagent reaction portion 21 is made of glass or quartz.

Where viscous reagents are used, the channels inside the reagent inlet portion 22 tend to be clogged up especially easily. Consequently, it can be anticipated that the running cost of the reactor in operation will be reduced by designing this portion tending to be clogged up as a replaceable external part attached to the reagent reaction portion 21.

### Third Embodiment

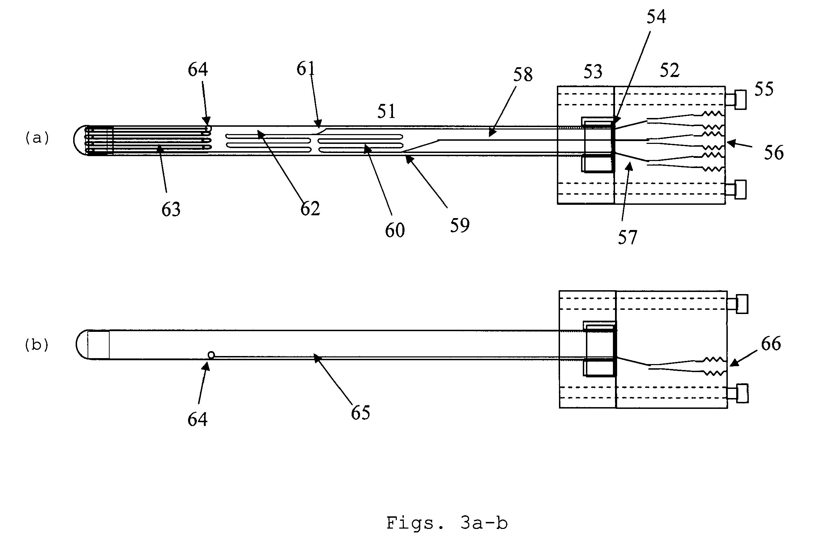

Fig. 3 shows an organic synthesis reactor according to a further embodiment of the present invention. Figs. 3a and 3b show a top and a bottom view, respectively. The reactor has a reagent inlet portion 52 that is connected at a contact portion 54 with a reagent reaction portion 51 via a connector jig 53 and using screws 55.

The reagent reaction portion 51 is made of a glass substrate having a thickness of 1 to 5 mm. Microchannels are formed on both surfaces of the glass substrate by wet etching or drilling. The glass substrate is provided with a through-hole 64 to permit a reagent solution to flow from the channel in the front surface to the channel in the rear surface.

The width and depth of the channels are 50 to 500 µm. The design of the channels and machining method can be modified according to the purpose of use.

The glass substrate having the microchannels are then held between two glass plates. These glass substrate and glass plates are bonded together by thermocompression. One end portion of the assembly is cut into an elongated T-shaped form. The end portion of the reagent reaction portion 51 is shaped like the letter T to press and join the reagent inlet portion 52 by the connector jig 53. The T-shaped end portion of the reagent reaction portion 51 is made asymmetrical right and left to prevent the senses of the reagent reaction portion 51 and reagent inlet portion 52 from being confused when they are connected. The connector jig 53 has a structure for recognizing the asymmetrical portion or an asymmetrical fitting portion.

Screw holes are formed in the reagent inlet portion 52 to permit connection of tubes. Also, channels are formed in the inlet portion 52. When the reagent reaction portion 51 and the reagent inlet portion 52 have been connected, their channels are aligned. Consequently, a reagent solution can be passed through the channels. The contact portion 54 is surface-treated or used in combination with a sealant to prevent liquid leakage.

Three reagent inlet holes 56 are formed in the reagent inlet portion 52 and are in communication via three reagent inlet channels 57, respectively, with three reaction liquid channels 58, respectively, formed in the reagent reaction portion 51.

Two of the 3 inlet holes 56 meet each other and are combined into one conduit in the first reaction-and-mixture portion 59. The conduit is in communication with the first reaction portion 60 of the bent channel, where a first reaction between reagents is produced. The conduit then meets another reaction liquid channel in the second reaction-and-mixture portion 61 to form one conduit which is in communication with the second reaction portion 62 of the bent channel, where a second reaction between the reagents is induced.

The second reaction portion 62 is in communication with a detection channel 63 of the bent channel. The second reaction liquid passes through a through-hole 64 and reaches the rear side of the reagent reaction portion 62, the through-hole 64 being formed in the vertical direction. The second reaction liquid then passes into the reaction liquid discharge hole 66 through a reaction liquid discharge channel 65. The 3 reagent inlet holes 56 and reaction liquid discharge hole 66 are formed in the same side surface of the reagent inlet portion 52.

In this way, in the present embodiment, the microchannels in the microchip are formed in both top surface side and bottom surface side of the reagent inlet portion 52 and reagent reaction portion 51. That is, the present embodiment is characterized in that there are two layers of channels.

Preferably, the material of the organic synthesis reactor is so selected that the reactor can be used in a temperature range from -70°C to +200°C. To permit mass production using a molding technique, the reagent inlet portion 52 is preferably made of a chemical resistant resin such as PEEK (polyetheretherketone), Teflon^{™}, or Diflon. Preferably, the reagent reaction portion 51 is made of glass or quartz.

Where viscous reagents are used, the channels inside the reagent inlet portion 52 tend to be clogged up especially easily. Consequently, it can be anticipated that the running cost of the reactor in operation will be reduced by designing this portion tending to be clogged up as a replaceable external part attached to the reagent reaction portion 51.

### Fourth Embodiment

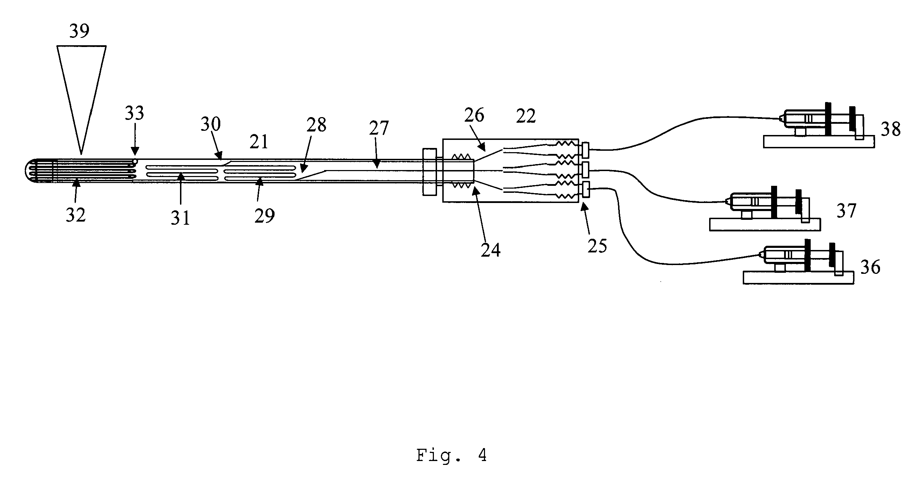

Fig. 4 shows one embodiment of the present invention in which such an organic synthesis reactor is mounted in various analytical instruments. Liquid delivery modules 36, 37, and 38 such as syringe pumps are connected with the organic synthesis reactor by tubes such as capillaries.

Reagent solutions sent out from the liquid delivery modules 36 and 37 are mixed by a mixing portion 28 where channels intersect. The solutions are reacted in a first reaction portion 29. The reagent solutions reacted in the first reaction portion are mixed with a reagent introduced from the liquid delivery module 38 in a mixing portion 30 located immediately behind the first reaction portion 29. Thus, a second stage of reaction is induced in a second reaction portion 31. Instead of the reagent, a reaction inhibitor or diluting solvent may be introduced from the liquid delivery module 38. The reaction liquid obtained in the second reaction portion 31 is introduced into a detection channel 32, where the reaction products are detected by a thermal lens microscope 39. Then, the reaction liquid is discharged out of the organic synthesis reactor from a reaction liquid discharge hole 35 through a through-hole 33 and through a reaction liquid discharge channel 34 in the rear surface. The liquid is then recovered.

### Fifth Embodiment

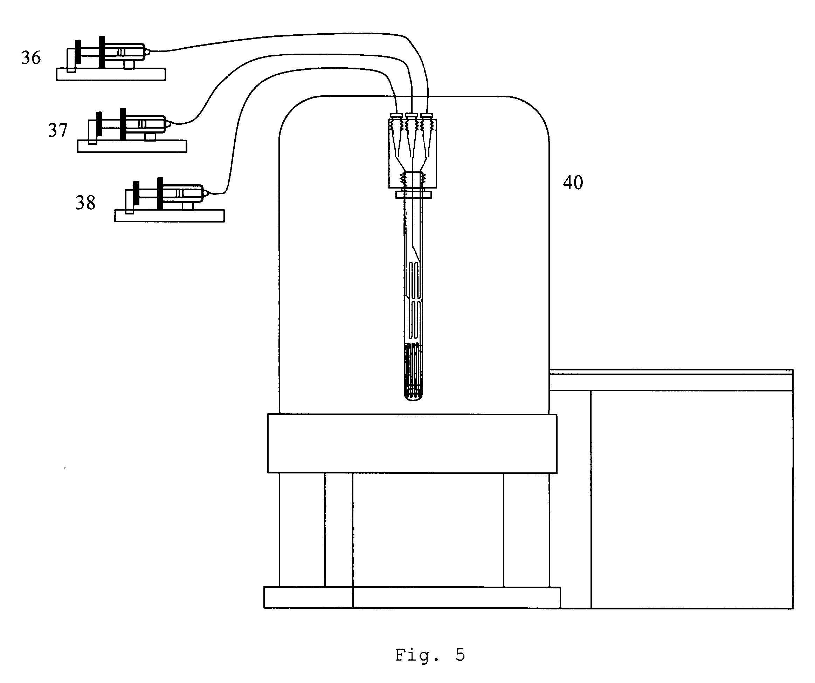

Fig. 5 shows an embodiment of the present invention in which the organic synthesis reactor is mounted in an NMR spectrometer. The organic synthesis reactor can be directly attached to the NMR spectrometer 40 of normal construction. The reactor and liquid delivery modules are connected by tubes such as capillaries. The reactor is mounted to an NMR sample tube holder having a diameter of 5 mm and to a rotor and inserted into an NMR probe having a diameter of 5 mm (finding the widest use). Under this condition, the reactor is used instead of an NMR sample tube. The organic synthesis reactor may also be combined with an electron spin resonance (ESR) spectrometer by a similar method.

### Sixth Embodiment

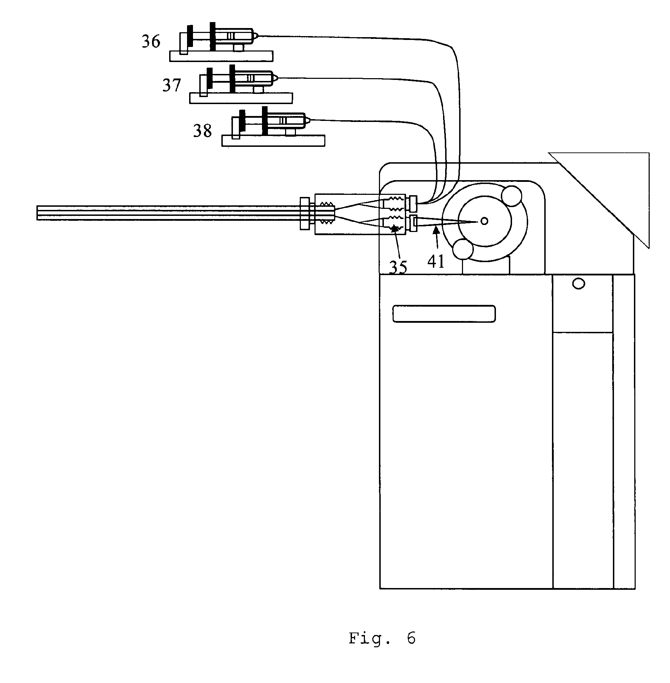

Fig. 6 shows an embodiment of the present invention in which the organic synthesis reactor is mounted in a mass spectrometer. With the organic synthesis reactor, MS detection can be easily performed simply by connecting a nano-electrospray nozzle 41 to a reaction liquid discharge hole 35. The operation regarding introduction of reagents is the same as in the third and fourth embodiments. In this embodiment, the reaction liquid is discharged from the nano-electrospray nozzle. Mass spectra of the reaction products within the reaction liquid can be measured by electrospray ionization caused by application of a high voltage.

The present invention can find wide application in research into organic synthesis and reactions.

## Claims

1. An apparatus for organic synthesis and reactions, the apparatus being adapted to mix plural fluids in a quite small space and to cause the fluids to react with each other at multiple stages, said apparatus comprising:
an introduction portion which introduces plural reagents from plural channels and which, when a need arises, mixes and reacts the reagents; and
a reaction portion disconnectably connected with the introduction portion and acting to cause a reagent or reaction liquid introduced from the introduction portion to mix and react with other reagent;
wherein said introduction portion has (a) an inlet channel for introducing a reagent, which is introduced from the outside, into said reaction portion and (b) a first discharge channel for discharging the reaction liquid, which is discharged from said reaction portion, to the outside; and
wherein said reaction portion has (a) a reaction channel in communication with said inlet channel and acting to cause plural reagents sent in from the inlet channel to mix and react with each other and (b) a second discharge channel for placing the reaction channel and the first discharge channel in communication with each other to return reaction liquid produced in the reaction channel into the introduction portion.

2. An apparatus for organic synthesis and reactions as set forth in claim 1, wherein said introduction portion is a microchip made of a substrate made of a chemical resistant resin and provided with microchannels, and wherein said reaction portion is a microchip made of a substrate of glass or quartz and provided with microchannels.

3. An apparatus for organic synthesis and reactions as set forth in any one of claims 1 and 2, wherein said introduction portion has inlet holes for introducing reagents and a discharge hole for discharging the reaction liquid, and wherein the inlet holes and the discharge hole are flush with each other.

4. An apparatus for organic synthesis and reactions as set forth in claim 2, wherein said microchannels are formed in both surfaces of a substrate of glass or quartz by wet etching or drilling, and wherein the apparatus is finished by holding the channeled substrate between two plates of glass or quartz and bonding together the substrate and plates by thermocompression after formation of the microchannels.

5. An apparatus for organic synthesis and reactions as set forth in claim 4, wherein said substrate has a thickness of 1 to 5 mm.

6. An apparatus for organic synthesis and reactions as set forth in claim 2, wherein said reaction portion assumes a cylindrical or prismatic form having a length of 50 to 300 mm and a maximum width of 2 to 10 mm.

7. An apparatus for organic synthesis and reactions as set forth in any one of claims 2 and 4, wherein said microchannels have a width and a depth of 50 to 500 µm.

8. An apparatus for organic synthesis and reactions as set forth in any one of claims 1 and 2, wherein said reaction portion has a detection portion for use with an analytical instrument for analyzing the reaction liquid.

9. An apparatus for organic synthesis and reactions as set forth in claim 8, wherein said analytical instrument is at least one of NMR, ESR, and thermal lens microscope.

10. An apparatus for organic synthesis and reactions as set forth in claim 3, wherein an electrospray nozzle for use with a mass spectrometer for analyzing the reaction liquid is mounted in the discharge hole in said introduction portion.
